(19) **Europäisches Patentamt**
**European Patent Office**
**Office européen des brevets**

(11) Veröffentlichungsnummer: **0 422 430 A2**

(12) # EUROPÄISCHE PATENTANMELDUNG

(21) Anmeldenummer: **90118205.5**

(22) Anmeldetag: **21.09.90**

(51) Int. Cl.⁵: **H01J 23/36**

Die Bezeichnung der Erfindung wurde geändert (Richtlinien für die Prüfung im EPA, A-III, 7.3).

(30) Priorität: **11.10.89 DE 3933875**

(43) Veröffentlichungstag der Anmeldung:
**17.04.91 Patentblatt 91/16**

(84) Benannte Vertragsstaaten:
**AT CH DE FR GB LI SE**

(71) Anmelder: **TECHNICS PLASMA GMBH**
**Dieselstrasse 22**
**W-8011 Kirchheim bei München(DE)**

(72) Erfinder: **Möhl, Wolfgang, Dr.**
**Dieselstrasse 22**
**W-8011 Kirchheim b. München(DE)**

(74) Vertreter: **Boeters, Hans Dietrich, Dr. et al**
**Boeters & Bauer Bereiteranger 15**
**W-8000 München 90(DE)**

(54) **Kupplungsstruktur zwischen Mikrowellen und Plasma.**

(57) Die Erfindung hat eine Vorrichtung zum Einkoppeln von Mikrowellen in einen Behandlungsraum, insbesondere zur Plasmaerzeugung, zum Gegenstand. Sie umfaßt einen Mikrowellengenerator, einen Hohlleiter, einen Hohlraumresonator und eine Quarzglasscheibe, wobei zwischen dem Hohlleiter und dem Hohlraumresonator ein Hornstrahler angeschlossen ist. Die Einkopplungsvorrichtung eignet sich sehr gut zum Einsatz beim Plasmaätzen in Hochfreguenzentladungen.

Fig.

EP 0 422 430 A2

## VORRICHTUNG ZUM EINKOPPELN VON MIKROWELLEN IN EINEN BEHANDLUNGSRAUM ZUR PLASMA ERZEUGUNG

Die Erfindung bezieht sich auf eine Vorrichtung zum Einkoppeln von Mikrowellen in einen Behandlungsraum, insbesondere zur Plasmaerzeugung, umfassend einen Mikrowellengenerator, einen Hohlleiter, einen Hornstrahler und eine Quarzglasscheibe.

Der Erfindung liegt die Aufgabe zugrunde, eine Vorrichtung zum Einkoppeln von Mikrowellen in einen Behandlungsraum zu schaffen, die einen kompakten Aufbau aufweist.

Diese Aufgabe ist erfindungsgemäß bei einer Vorrichtung mit den Merkmalen des Anspruchs 1 gelöst. Vorteilhafte Weiterbildungen der erfindungsgemäßen Einkopplungsvorrichtung sind Gegnstand der Unteransprüche.

Eine erfindungsgemäße Vorrichtung zum Einkoppeln von Mikrowellen in einen Behandlungsraum, insbesondere zur Plasmaerzeugung, umfaßt somit einen Mikrowellengenerator, einen Hornstrahler und eine Quarzglasscheibe.

Durch die Kombination des Hornstrahlers mit dem Hohlleiter wird eine besonders vorteilhafte Einkopplung der Mikrowellen bewirkt. Durch die Wahl des Hornkonuswinkels und der Horn länge kann eine gewünschte Richtcharakteristik der Mikrowellenstrahlung erzielt werden. Außerdem kann das erweiterte Ende des Hornstrahlers relativ dicht an die Quarzglasscheibe gelegt werden, was ebenfalls zu einer Verringerung des Raumbedarfs führt. Die erfindungsgemäße Einkopplungsvorrichtung ist daher außerordentlich kompakt und zeichnet sich außerdem durch einen hohen Kopplungsgrad aus. Sie eignet sich besonders gut zur Erzeugung großvolumiger Plasmen bis zu 2,5 m³, beispielsweise zum Plasmaätzen in Hochfrequenzentladungen.

Vorzugsweise ist die Quarzglasscheibe als Quarzglasdom ausgebildet, was für die Plasmaerzeugung günstig ist. Die Wahl einer großen Öffnungsweite des Quarzglasdoms ermöglicht einen vorteilhaften Einsatz der Einkopplungsvorrichtung insbesondere bei Behandlungskammern, in denen mit möglichst hohem Wirkungsgrad Plasma erzeugt werden soll.

Bei einer bevorzugten Ausführungsform der erfindungsgemäßen Einkopplungsvorrichtung ist der Hohlleiter mit einer oder mehreren, insbesondere drei Abstimmschrauben versehen. Eine Verstellung der Abstimmschrauben von außen ermöglicht eine Anpassung der Impedanz.

Vorteilhaft ist der Mikrowellengenerator seitlich am oberen Endbereich des Hohlleiters angeordnet. Hierdurch ergibt sich eine Verringerung des vertikalen Aufbaus der erfindungsgemäßen Einkopplungsvorrichtung.

Bei einer praktischen Realisierung der erfindungsgemäßen Einkopplungsvorrichtung ist das vordere Ende des Hornstrahlers vorteilhaft in einer Montageplatte bündig angebracht. Hierdurch ist die Montage des Hornstrahlers mit zugehörigen Einheiten vereinfacht und er kann optimal an die Halterung der Quarzglasscheibe etc. angepaßt werden.

Günstig ist eine einstückige Ausbildung des Hornstrahlers mit dem Hohlleiter. Hierdurch ist der Montageaufwand verringert und der Aufbau besonders einfach.

Eine weiter bevorzugte Ausführungsform der erfindungsgemäßen Einkopplungsvorrichtung zeichnet sich dadurch aus, daß der Quarzglasdom von einem Halterungsblock seitlich umgeben ist, der auf der Oberseite eine Ausnehmung zur Aufnahme der Montageplatte des Hornstrahlers aufweist.

Zweckmäßig weist der Halterungsblock eine konisch zum Hornstrahler hin zulaufende Innenwand auf, wodurch die Richtcharakteristik der Einkopplungsvorrichtung weiter verbessert ist.

Vorzugsweise schließt der Quarzglasdom mit der Wand des Behandlungsraum im wesentlichen bündig ab, so daß die axiale Erstreckung der erfindungsgemäßen Einkopplungsvorrichtung gering gehalten ist.

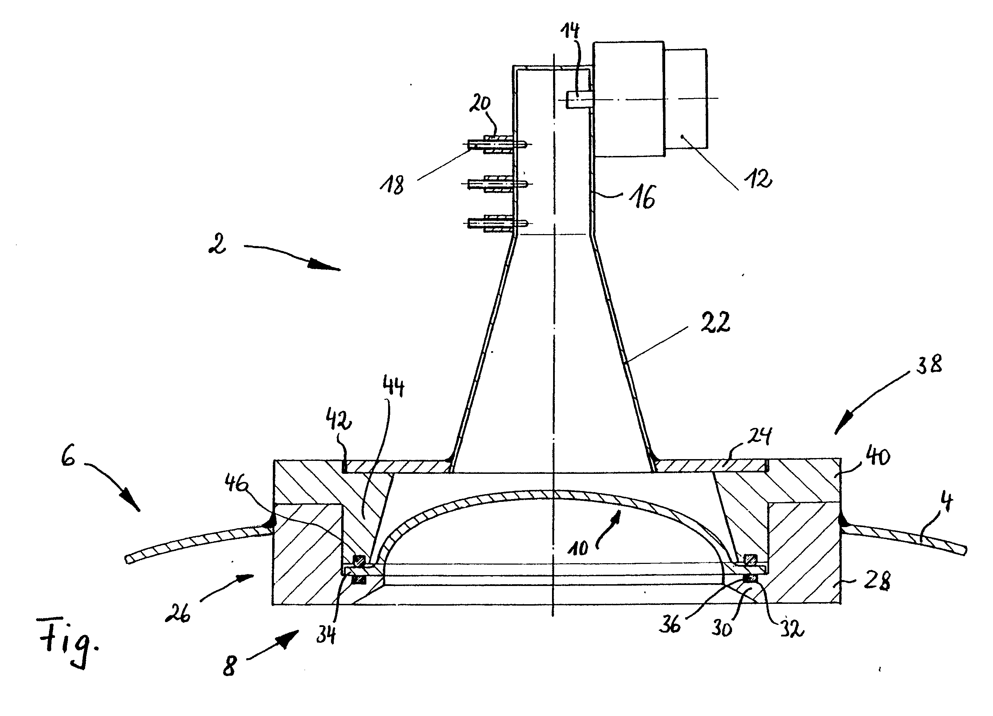

Die Erfindung wird im folgenden weiter anhand eines bevorzugten Ausführungsbeispiels und der Zeichnung erläutert. In der Zeichnung zeigt die einzige Figur eine Längsschnittansicht der Einkopplungsvorrichtung nach der Erfindung.

In der Zeichnung ist eine Einkopplungsvorrichtung 2 im eingebauten Zustand in einer Wandung in der Behandlungskammer 6 dargestellt. Die Wandung 4 weist eine größere Öffnung 8 auf, die durch einen Quarzglasdom 10 mit zugehörigen Halterungseinrichtungen etc. verschlossen ist. Der Quarzglasdom 10 bildet den Abschluß der Einkopplungsvorrichtung 2.

Die Einkopplungsvorrichtung 2 umfaßt einen Mikrowellengenerator 12, bei dem es sich im gezeigten Ausführungsbeispiel um ein Magnetron mit 2,45 GHz handelt. Mit seinem Einkopplungsende 14 ragt der Mikrowellengenerator in einen Hohlleiter 16 zur Mikrowelleneinkopplung. Im mittleren und unteren Bereich weist der Hohlleiter 16 außen am Gehäuse axial zueinander angeordnet drei Buchsen 20 auf, die sich vom Außenumfang radial nach außen erstrecken. In den Buchsen 20 sitzen Abstimmschrauben 18, die sich durch die Wand des Hohlleiters 16 nach innen erstrecken. Die Abstimmschrauben sind zur Anpassung der Impedanz vorgesehen.

Der Hohlleiter 16 geht am unteren Ende einstü

kig in einen Hornstrahler 22 über, dessen Konuswinkel und Konuslänge speziell für die Behandlungskammer 6 berechnet worden ist. Im Bereich des unteren Endes ist der Hornstrahler 22 bündig in einer Montageplatte 24 angebracht. Die Halterung ist zum einen durch festen Sitz und zum anderen durch Verschweißung erfolgt.

In der Öffnung 8 der Wandung 4 der Behandlungskammer 6 sitzt ein Halterungseinsatz 26, der mit der Wandung 4 verschweißt ist. Der Halterungseinsatz 26 besteht aus einem Ringkörper 28 zylindrischer Form, der im unteren Endbereich einen sich radial nach innen erstreckenden Vorsprung 30 aufweist. Der Vorsprung 30 ist auf der Unterseite abgeschrägt ausgebildet und weist auf der Oberseite eine ebene Auflage mit einer Vertiefung 32 auf. Auf der ebenen Auflage des Vorsprungs 30 ruht ein unterer radialer Flansch 34 des Quarzglasdoms 10. Durch den radialen Flansch 34 erstreckt sich eine Befestigungseinrichtung 36 in die Vertiefung 32. Die Innenwölbung des Quarzglasdoms 10 verläuft bündig mit der Stirnfläche des Vorsprungs 30.

Auf dem Halterungseinsatz 26 sitzt ein Halterungsblock 38, der den Quarzglasdom 10 seitlich umgibt. Der Halterungsblock 38 ist scheibenförmig ausgebildet und weist einen Ringkörper 40 mit einer Ausnehmung 42 zur Aufnahme der Montageplatte 24 des Hornstrahlers 22 auf. Vom Ringkörper 40 erstreckt sich auf der radialen Seite ein Zylinderring 44 nach unten, der auf seiner unteren Stirnseite eine Vertiefung 46 zur Aufnahme eines Teils der Befestigungseinrichtung 36 aufweist. Im gezeigten Ausführungsbeispiel ist der Zylinderring 44 auf der Innenseite konisch nach unten, d.h. zur Behandlungskammer 6 hin, erweitert. Der Halterungsblock 38 sitzt fest auf dem Halterungseinsatz 26 mit der erforderlichen Abdichtung.

Die oben beschriebene Einkopplungsvorrichtung 2 wird zur Erzeugung großvolumiger Plasmen eingesetzt. Selbstverständlich sind auch andere Verwendungen möglich.

## Ansprüche

1. Vorrichtung zum Einkoppeln von Mikrowellen in einen Behandlungsraum, insbesondere zur Plasmaerzeugung, umfassend einen Mikrowellengenerator, einen Hohlleiter und eine Quarzglasscheibe, dadurch **gekennzeichnet,** daß zwischen dem Hohlleiter (16) und dem Quarzglasdom (10) ein Hornstrahler (22) angeschlossen ist.

2. Einkopplungsvorrichtung nach Anspruch 1, dadurch **gekennzeichnet,** daß die Quarzglasscheibe (10) ein Quarzglasdom ist.

3. Einkopplungsvorrichtung nach Anspruch 1 oder 2, dadurch **gekennzeichnet,** daß der Hohlleiter (16) mit einer oder mehreren Abstimmschrauben (18) versehen ist.

4. Einkopplungsvorrichtung nach Anspruch 3, dadurch **gekennzeichnet,** daß drei Abstimmschrauben (18) vorgesehen sind.

5. Einkopplungsvorrichtung nach einem der Ansprüche 1 bis 4, dadurch **gekennzeichnet,** daß der Mikrowellengenerator (12) seitlich am oberen Endbereich des Hohltleiters (16) angeordnet ist.

6. Einkopplungsvorrichtung nach einem der Ansprüche 1 bis 5, dadurch **gekennzeichnet,** daß das vordere Ende des Hornstrahlers (22) in einer Montageplatte (24) bündig angebracht ist.

7. Einkopplungsvorrichtung nach einem der Ansprüche 1 bis 6, dadurch **gekennzeichnet,** daß der Hornstrahler (22) einstückig mit dem Hohlleiter (16) ausgebildet ist.

8. Einkopplungsvorrichtung nach einem der Ansprüche 2 und 6 oder 7, dadurch **gekennzeichnet,** daß der Quarzglasdom (10) von einem Halterungsblock (38) seitlich umgeben ist, der auf der Oberseite eine Ausnehmung (42) zur Aufnahme der Montageplatte (24) des Hornstrahlers (22) aufweist und mit dem Quarzglasdom (10) der Montageplatte (24) und dem Hornstrahler (22) eine Einheit bildet.

9. Einkopplungsvorrichtung nach Anspruch 8, dadurch **gekennzeichnet,** daß der Halterungsblock (38) eine konisch zum Hornstrahler (22) hin zulaufende Innenwand aufweist.

10. Einkopplungsvorrichtung nach einem der Ansprüche 1 bis 9, dadurch **gekennzeichnet,** daß der Quarzglasdom (10) mit der Wand des Behandlungsraums (6) im wesentlichen bündig abschließt.

Fig.

4